# EUROPEAN PATENT APPLICATION

(11) **EP 4 495 691 A1**
(43) Date of publication of application: **22.01.2025**
(21) Application number: 23186017.2
(22) Date of filing: 18.07.2023
(51) Int. Cl.: G03F 7/20

(54) **RELIEF FORMING PLATE PRECURSORS**

(71) Applicant: ECO3 BV, 2640 Mortsel (BE)
(72) Inventor: BILLIET, Thomas, 2640 Mortsel (BE); ARAUJO, Adelaide, 2640 Mortsel (BE)
(74) Representative: De Clercq & Partners

(57) **Abstract**

An improved mask-forming film characterized by both a high IR sensitivity and a high UV density in combination with improved cosmetic and physical properties is disclosed; and an improved method for making a relief-forming precursor using this film. The mak-forming film has the specific features that it comprises a coating including a polysiloxane compound.

## Description

### Technical Field

The present invention relates to a method for the preparation of a relief printing element using a removable film. In particular, this invention relates to mask-forming films that are suitable for preparing flexographic printing plates.

### Background Art

Relief printing plates are p1ates having image areas raised above open areas. Generally, the plate is somewhat soft, and flexible enough to wrap around a printing cylinder, and durable enough to print many copies. Flexography is commonly used for high-volume runs and employed for printing on a variety of substrates such as paper, paperboard, corrugated board, films, foils and laminates. Especially for printing on coarse surfaces and stretch films, flexography is of interest.

Many methods for making relief images are known in the graphic arts. Photosensitive materials comprising an ablatable or mask layer on the surface of a photosensitive layer, a so-called "integral mask" or "in-situ mask" may be used for preparing a relief image without the use of a photographic negative or separate masking elements. These photosensitive materials are formed into relief images by first image-wise exposing the photosensitive material with laser radiation to selectively remove the layer in the exposed areas, i.e. forming a mask, followed by overall exposure with actinic radiation to cure the photosensitive layer in the unmasked areas. The remaining areas of the mask layer and the non-hardened portions of the photosensitive layer are then removed by one or more liquid development processes. Examples of flexographic materials having an integral mask are for example described in for example EP 3 047 336 and EP 3 304 203.

The resulting surface, after development, has a relief pattern that reproduces the image to be printed and which typically includes both solid areas and patterned areas comprising a plurality of relief dots. After the relief image is developed, the relief image printing element may be mounted on a press and printing commenced.

Such flexographic printing plates having an in-situ laser-ablatable mask layer, allow direct imagewise exposure using a laser and do not require a separate masking device. However, the sensitivity to imaging radiation is rather low and high-powered laser-equipped imaging apparatuses are often required. Indeed, the sensitivity is generally not lower than about 1 J/cm², and typically about 3 J/cm² is required for laser-ablation. Many attempts have been made in the industry to overcome this problem by increasing the infrared sensitivity of the mask layer. However, obtaining a higher sensitivity has been a challenge due to the various quality criteria that must be simultaneously satisfied. Furthermore, because of the need of flexographic printing plates with different thicknesses depending upon the specific intended uses, more than one imaging apparatus may be required for the in-situ integral-mask approach.

Alternative methods include making an article bearing a relief image by first forming a mask image on a base material, for example by thermally imaging a suitable mask film or masking element to provide the desired pattern (generally using an infrared radiation laser under computer control), followed by transferring the mask image to a photosensitive material, and exposing the photosensitive material to a curing radiation, typically ultraviolet radiation.

In the latter method, a mask may be formed by exposing a mask layer provided on a base material to laser radiation, generally infrared radiation. In the imaging process, the exposed regions may be removed by for example laser ablation. The ablation of the mask layer may be performed by means of various lasers. Preferably, lasers which emit light in the near IR wavelength range are used. They include for example, IR laser diodes (830 nm) or Nd-YAG solid-state lasers or fiber lasers (1064 or 1100 nm, respectively). In order to obtain effective ablation of the mask layer, efficient absorption of the laser beam is crucial. Therefore, often infrared absorbers such as finely dispersed carbon black or IR-absorbing dyes are used in the mask layer. The base material of the mask film is preferably transparent for UV light, such as for example transparent polyester films. The imaged mask film is subsequently placed onto a photosensitive material for overall exposure with actinic radiation, e.g. UV radiation, to cure the photosensitive material in the unmasked areas, thus forming a negative image of the mask element in the photosensitive relief-forming precursor.

The mask film and the photosensitive material are brought into intimate contact by for example using a laminator device or vacuum drawdown, or both, and subjected to overall exposure with actinic radiation (for example, UV radiation) to cure the photosensitive composition in the relief-forming precursor in the unmasked areas.

Air and/or void space trapped between the mask film and the photosensitive material should be avoided in order to obtain optical contact bonding between both. If optical contact bonding is not achieved, the light used in the exposure step may scatter due to the space and/or trapped air resulting in a relief image that is not an exact representation of the intended image on the film mask.

Alternative methods to provide optical contact bonding between the mask film and the photosensitive material have been proposed in the art. For example, by using an imaged film that adheres to the photosensitive material during the curing step, so that the vacuum draw-down step is not needed. Also, vacuum has been successfully replaced in the art by application of pressure or elevated temperature to laminate the mask film onto the photosensitive material.

The assembly of the imaged mask film and the photosensitive material is subsequently imaged with UVA. The exposed regions of the photosensitive material harden or cure and become insoluble in developing liquids while the unexposed regions remain soluble. The cured portions define the printing areas and remain on the printing plate. The mask element can then be removed and the remaining areas of the mask layer and the non-hardened portions of the photosensitive material are washed away by one or more liquid development processes, for example aqueous or solvent processing. After drying, the resulting imaged relief-forming precursor has a relief image that can be used for for example flexographic or letterpress printing operations.

EP 1146 392 discloses a method for making a relief image by laminating an ablatable mask layer to a UV-sensitive material with the use of an adhesive layer to create an integral mask on the UV-sensitive material before the imaging/curing step.

EP 1 735 664 discloses a method including the steps of forming a transferable mask on a carrier sheet including an imageable layer, and transferring the mask image to a photosensitive material that is sensitive to UV curing radiation, such that the imageable material adheres more to the photosensitive material than to the carrier sheet.

EP 1 883 858 discloses a method of making a relief image comprising the steps of laminating an imaged film to a heated imageable article comprising a releasing layer disposed on a photosensitive material, followed by exposing the imageable article without vacuum draw-down to curing radiation through the imaged film. The subsequently removed image film from the imageable article is reusable.

EP 2 987 030 discloses an imageable material consisting essentially of a transparent polymeric carrier sheet, a barrier layer comprising a first infrared radiation absorbing compound, wherein the carrier sheet and/or barrier layer comprise a first ultraviolet radiation absorbing compound, and a non-silver halide thermally sensitive imageable layer comprising a second infrared radiation absorbing compound and a second ultraviolet radiation absorbing compound.

EP 2 153 278 discloses a method for making a relief image comprising the steps of laminating onto a heat-sensitive element, a mask including a film comprising an imageable layer on a transparent carrier sheet which includes a transparent layer which has a refractive index lower than the carrier sheet or lower than any optional layers between the carrier sheet and the transparent layer.

EP 3 323 017 discloses a laser-ablatable mask film for exposing relief printing plates comprising (i) a dimensionally stable base sheet (ii) a UV-transparent adhesion layer and (iii) a laser-ablatable mask layer comprising a crosslinked polyvinyl alcohol and a material which absorbs UV/VIS light and IR light such as carbon black.

EP 3 752 885 discloses an imageable material including a transparent carrier sheet; a non-ablatable light-to-heat converting layer comprising an infrared absorber, a crosslinked binder and non-thermally ablatable particles; and a thermally ablatable imaging layer comprising a second infrared absorber and a UV-light absorber dispersed in a thermally-ablatable polymeric binder.

In the art, there is an ongoing need to further improve the quality of the imageable film and the related method for making a relief printing plate.

### Summary of invention

It is an object of the present invention to provide an improved mask-forming film characterized by both a high IR sensitivity and a high UV density in combination with improved cosmetic and physical properties; and an improved method for making a relief-forming precursor using this film.

These objects are realised by the film and the method for making the relief printing element as defined in independent claims 1 and 12 with preferred embodiments defined in the dependent claims. The method for making a relief printing plate comprises the steps of (i) image wise exposing the imageable film whereby a mask image is formed; (ii) laminating the mask image to a relief-forming precursor; (iii) exposing the precursor including the mask image to curing radiation; (iii) removing the mask image from the relief-forming precursor; and (iv) developing the relief-forming precursor to form the relief printing plate.

The imageable film has the specific features that it comprises a coating including a polysiloxane compound and a carrier sheet which is preferably an untreated plastic film or sheet. It was surprisingly found that the addition of the polysiloxane compound highly improves the cosmetic and physical properties of the imageable film without reducing its the ablative sensitivity. Moreover, it was observed that the removal of the mask film after the UV exposure step is highly improved. Indeed, after the exposure step and before development, the assembly of the imaged relief-forming precursor and the mask is preferably delaminated by manually peeling the two elements apart by for example pulling the carrier sheet including the mask away from the imaged relief-forming precursor, and/or in an automated way. In this invention, it was surprisingly observed that the delamination is much more convenient due to a reduced pull-off force. Moreover, as the initial pull-off force is even more reduced, delamination can be easily carried out by only one operator in case of manual handling.

Other features, elements, steps, characteristics and advantages of the present invention will become more apparent from the following detailed description of preferred embodiments of the present invention. Specific embodiments of the invention are also defined in the dependent claims.

### Description of embodiments

### Definitions:

The "(imageable) film" described herein refers to "a mask element", "mask(ing) film", or "masking element". Upon imaging, the film contains a "mask image" and may be known as a "mask", "imaged film", or "imaged masking film".

The term "relief-forming precursor" or "photosensitive material" as used herein refers to any imageable element or imageable material in which a relief image can be produced by exposure through the imaged mask film. Examples of such relief-forming precursors include for example flexographic printing plate precursors, letterpress printing plate precursors, and printed circuit boards.

The term "relief printing element" or "relief printing plate" refers to an element including a relief image such as a flexographic printing plate, a letterpress printing plate and printed circuit boards.

The term "ablative" means that the imageable layer of the film can be imaged using a thermal ablating means such as laser radiation that causes rapid local changes in the imageable layer thereby causing the material(s) in the imageable layer to be ejected from the layer. This is distinguishable from other material transfer or imaging techniques in that a chemical change (for example, melting, evaporation, or sublimation) rather than a physical change is the predominant mechanism of imaging.

The term "hardened" means that the coating becomes insoluble or non-dispersible in the developing solution and may be achieved through polymerization and/or crosslinking of the photosensitive coating.

"Optical contact" means that two layers or two elements (for example the imaged masking film and the radiation-sensitive element) are in intimate contact so that there is essentially no air-gap or void between the contacted surfaces, thus providing an "air-free interface".

The use of numerical values in the various ranges specified herein, are considered to be approximations as though the minimum and maximum values within the stated ranges are preceded by the word "about." In this manner, slight variations above and below the stated ranges may be useful to achieve substantially the same results as the values within the ranges. In addition, the disclosure of these ranges is intended as a continuous range including every value between the minimum and maximum values as well as the end points of the ranges.

On site preparation refers to the performance by the end-user of the whole process: i.e. image-wise exposing, (de)laminating, flood exposing and developing.

Unless otherwise noted, the term "transparent" used herein refers to the ability of a material or layer to transmit at least 95% of incident electromagnetic radiation, such as electromagnetic radiation having a wavelength of at least 200 nm to and including 750 nm (generally known as respectively UV and visible radiation).

### Relief-forming precursor

Relief-forming precursors typically contain a UV sensitive layer on a dimensionally stable support. Preferably, the relief-forming precursor is a flexographic printing plate precursor, a letterpress printing plate precursor or a printed circuit board. Most preferably the relief-forming precursor is a flexographic printing plate precursor.

Suitable supports include dimensionally stable polymeric films and aluminum sheets. Polyester films are particularly useful. Optionally the support may be coated with additional layers e.g. an adhesion improving layer.

The support is typically about 20 - 200 microns thick. Optionally, the support may be pretreated in order to modify its wettability and/or adhesion behaviour to subsequently applied coatings. Such surface treatments include corona discharge treatment, application of a subbing layer, a release layer and/or an adhesive layer such as an acrylic or vinyl acetate adhesive.

The relief-forming precursor can be positive or negative-working, but is typically negative-working and preferably includes a photopolymerizable layer (photocurable or relief-image forming layer). The photopolymerizable layer preferably comprises an elastomeric binder and a UV curable composition that can be cured or hardened by mainly polymerization and/or crosslinking upon exposure to UV radiation. The UV curable composition preferably comprises polymerizable or photocurable monomer(s) and at least one photoinitiator.

Suitable polymerizable monomers include ethylenically unsaturated polymerizable compounds having relatively low molecular weight (generally less than 30,000 Daltons) such as for example polymerizable monomers including various mono- and polyacrylates, acrylate derivatives of isocyanates, esters, and epoxides. Specific suitable monomers include, but are not limited to t-butyl acrylate, lauryl acrylate, the acrylate and methacrylate mono- and polyesters of alcohols and polyols such as alkanols, e. g. , 1, 4-butanediol diacrylate, 2, 2, 4-trimethyl-1, 3 pentanediol dimethacrylate, and 2, 2-dimethylolpropane diacrylate, alkylene glycols, e. g., tripropylene glycol diacrylate, butylene glycol dimethacrylate, hexamethylene glycol diacrylate, and hexamethylene glycol dimethacrylate, trimethylol propane, ethoxylated trimethylol propane, pentaerythritol, e. g. , pentaerythritol triacrylate, dipentaerythritol, and the like. Other examples of suitable monomers include acrylate and methacrylate derivatives of isocyanates, esters, epoxides and the like, such as decamethylene glycol diacrylate, 2, 2-di(phydroxyphenyl)propane diacrylate, 2, 2-di(p-hydroxyphenyl)propane dimethacrylate, polyoxyethyl-2, 2-di(p-hydroxyphenyl)propane dimethacrylate, and 1-phenyl ethylene-1, 2-dimethacrylate. The typical amount of one or more polymerizable monomers in the UV-sensitive layer is at least 5 weight % and up to and including 25 weight %, based on total dry weight of the UV-sensitive layer.

The photoinitiator can be a single compound or combination of compounds that are sensitive to UV radiation and that generate free radicals that initiate the polymerization of the polymerizable monomer(s) without excessive termination. They are preferably present in an amount of about 0.001 weight % and up to and including 10 weight % based on the total dry weight of the UV sensitive layer. Examples of suitable photoinitiators include but are not limited to optionally substituted polynuclear quinones, vicinal ketaldonyl alcohols, alphahydrocarbon-substituted aromatic acyloins, dyes of the phenazine, oxazine, and quinone classes and cyclohexadienone compounds.

The elastomeric binder preferably comprises polymers or resins that are preferably soluble, swellable or dispersible in aqueous, semi-aqueous, or organic solvent developers. Suitable examples include, but are not limited to, natural or synthetic polymers of conjugated diolefin hydrocarbons including polyisoprene, 1, 2-polybutadiene, 1, 4-polybutadiene, butadiene/acrylonitrile, block copolymers such as for example butadiene/styrene thermoplastic-elastomeric block copolymers, coreshell microgels, and blends of microgels and preformed macromolecular polymers. The elastomeric binder can comprise at least 65 weight % and up to and including 90 weight %, based on total dry UV-sensitive layer weight.

The UV-sensitive layer may include other compounds that provide various properties including but not limited to sensitizers, plasticizers, rheology modifiers, thermal polymerization inhibitors, tackifiers, colorants, antioxidants, anti-ozonants, and fillers; in amounts that are known in the art. Examples of suitable plasticizers include aliphatic hydrocarbon oils, e. g. naphthenic and paralfinic oils, liquid polydienes such as liquid polybutadiene, liquid polyisoprene. Generally, plasticizers are liquids having molecular weights of less than about 5.000 Daltons, but can have molecular weights up to about 30.000 Daltons.

The thickness of the UV-sensitive layer is preferably at least 500 µm and up to and including 6400 µm in average dry thickness.

The relief-forming precursor may be protected against mechanical damage by for example a removable protective or cover film or sheet located on the uppermost layer. The cover sheet should be removed before placing the mask image in proximity of the relief-forming precursor. Useful cover sheets include flexible polymeric films, e.g., polystyrene, polyethylene, polypropylene, polycarbonate, fluoropolymers, polyamide or polyesters. Preferably polyesters are used, especially polyethylene terephthalate.

### Film

In the present invention, a novel film is used to form a mask image. The film comprises at least one imageable layer and a carrier sheet. The imageable layer is generally disposed on the carrier sheet as a relatively uniform coating of one or more layers. Preferably, the film includes one imageable layer. The film may optionally further include one or more additional layers, such as for example a barrier layer.

### Carrier sheet

The carrier sheet of the film may be any suitable substrate. Suitable substrates include, for example, plastic sheets and films, such as polyethylene terephthalate or polyethylene naphthalate, fluorene polyester polymers, polyethylene, polypropylene, polybutadienes, polyacrylates, polycarbonates, polyvinyl chloride and copolymers thereof, and hydrolyzed and non-hydrolyzed cellulose acetate. The carrier sheet should preferably be sufficiently transparent to the imaging radiation and is preferably a transparent polymeric film. A preferred carrier sheet is a polyethylene terephthalate sheet and is about 20 µm to about 200 µm thick.

The carrier sheet used in the present invention is preferably an untreated or unsubbed plastic film or sheet, i.e. a plastic film or sheet which has not been treated with any (transparent) coating layers such as for example an adhesion promoter layer, a release layer, a subbing layer, a scratch resistant (hardcoat) layer or a hardened gelatin layer.

### The imageable layer

The imageable layer is preferably provided on the carrier sheet as a continuous, uniform coating. Preferably, one imageable layer is present on the carrier sheet but optionally more than one imageable layer may be present on the carrier sheet. Between the carrier sheet and the imageable layer optionally other non-transparent layers such as for example a barrier layer may be present. A barrier layer may include for example metal oxide particles, e.g. iron oxide particles.

The components of the imageable layer are preferably soluble or swellable in suitable developers including both chlorinated organic solvents and non-chlorinated organic solvents - as described below.

The imageable layer includes a polysiloxane compound. The polysiloxane compound preferably comprises siloxane units which may be a linear, branched, cyclic or complex cross-linked polymer or copolymer. The term polysiloxane compound includes any compound which contains more than one siloxane group -Si(R,R')-O-, wherein R and R' are optionally substituted alkyl or aryl groups. Preferred siloxanes are phenylalkylsiloxanes and dialkylsiloxanes, e.g. phenylmethylsiloxanes and dimethylsiloxanes. The number of siloxane groups -Si(R,R')-O- in the (co-)polymer is at least 2, preferably at least 10, more preferably at least 20. It may be less than 100, preferably less than 60. The polysiloxane compound further preferably includes an alkylene-oxide block preferably including units of the formula -CnH₂ₙ-O- wherein n is preferably an integer in the range 2 to 5. The moiety - CnH₂ₙ- may include straight or branched chains. The alkylene-oxide block moiety may also comprise optional substituents. A suitable polysiloxane compound is preferably a random or block-copolymer comprising siloxane and alkyleneoxide groups, suitably comprising about 15 to 25 siloxane units and 50 to 70 alkyleneoxide groups. Preferred polysiloxanes include a copolymer of dimethyldichlorosilane, ethylene oxide and propylene oxide. Specific compounds are the following: 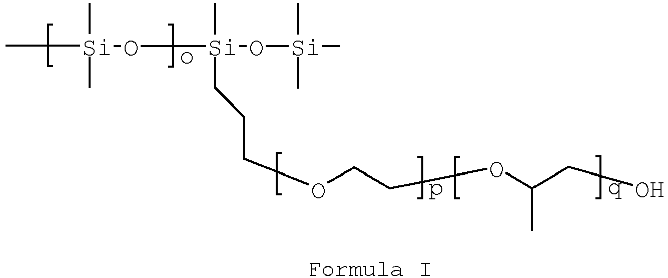 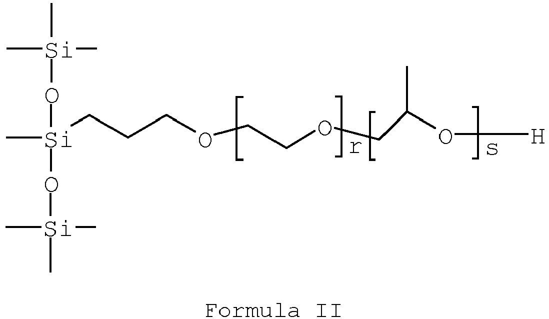 wherein o, p, q, r and s are integers >1

In formula I, a poly(alkylene oxide) block consisting of ethylene oxide and propylene oxide units is grafted to a polysiloxane block. In formula II, long chain alcohols consisting of ethylene oxide and propylene oxide units are grafted to a trisiloxane group.

The polysiloxane compound is preferably present in the imageable layer in an amount between 0.01 to 1.5%wt, more preferably between 0.04 to 1.0%wt and most preferably between 0.1%wt to 0.5%wt.

The imageable layer is preferably a laser ablatable layer and preferably includes a heat combustible polymeric binder and an IR light absorbing compound to sensitize the imageable layer to imaging IR radiation. The heat-combustible polymeric binder can optionally be present in an optional other layer. The heat-combustible polymeric binder can be decomposed, depolymerized or evaporated without a preceding melting step by the heat generated by the IR light absorbing compound upon laser exposure. Binders that are easily thermally combustible and generate gases and volatile fragments at temperatures below about 200 °C are preferred. The heat-combustible polymeric binder preferably comprises nitro groups or nitrate ester groups. Especially nitrate esters of cellulose or cellulose derivatives such as cellulose ethers, methyl cellulose, ethyl cellulose, nitrocellulose, 2-hydroxyethyl cellulose, 2-hydroxypropyl cellulose, carboxymethyl cellulose, cellulose ethers, polycarbonates, polyurethanes, polyesters, polyorthoesters, polyacetals, and copolymers thereof are preferred binders. Further examples of heat-combustible binders include poly (glycidyl azide), poly (glycidyl nitrate) or poly (vinyilnitrate), nitro derivatives of polystyrene such as polymers comprising nitro-, dinitro- or trinitro-styrene groups; polyacrylates or polymethacrylates such as polymers comprising 2,4-dinitrophenyl acrylate or p-nitrophenylacrylate as monomers; and/or combinations thereof.

In general, the heat-combustible polymeric binder is present for about 5 - 80%wt, preferably 8-60%wt and more preferably 10 - 40%wt based on the total amount of the ingredients in the imageable layer.

The preferred IR light absorbing compounds convert infrared radiation, for example in the range of 750-1500 nm, to heat. The generation of heat in the imageable layer may then result in a physical or chemical change in the other components of the imageable layer, most preferably induce ablation. Preferred IR light absorbing compounds include IR light absorbing dyes such as phthalocyanine dyes, cyanine dyes, merocyanine dyes and polymethine dyes and/or derivatives thereof; metals such as aluminum or inorganic pigments such as carbon black, graphite, iron oxide or chromium oxide. Carbon black - e.g. fine-grained carbon black with a mean particle size below 30 nm - renders, in addition to IR light, the ablatable layer also opaque to UV radiation.

The IR light absorbing compound is preferably sensitive to radiation in the range of about 700 to 1500 nm, more preferably in the range of about 750 to 1200 nm. A mixture of infrared light absorbing dyes which can absorb at different wavelengths, for example at about 830 nm and about 1064 nm may be used. The IR light absorbing compound is preferably present in an amount of about 1 to 30 %wt, more preferably in an amount of 10 to 26 %wt, and most preferably in an amount between 15 and 25 %wt based on the dry content of the imageable layer. Alternatively, the infrared light absorbing compound is present in an amount below 28 %wt, more preferably in an amount below 26 %wt and most preferably in an amount below 25 %wt based on the dry content of the imageable layer.

The imageable layer preferably includes one or more UV absorbers capable of strong absorbance and/or blocking of the curing radiation, for example by reflectance. The UV absorber substantially prevents the transmission of curing radiation through the mask image. Suitable examples of UV absorbers for use in the imageable material include mixtures of dyes and/or pigments dispersed within a polymeric binder(s) with or without the aid of a dispersant. Pigments may be preferred because they do not tend to migrate. The use of pigment dispersions in imaging is well-known in the art, and any conventional pigments useful for that purpose may be used in the present invention. It is particularly preferred that the pigments or dyes are non-IR absorbing so that imaging of the radiation-sensitive element is not adversely affected.

The UV absorber preferably absorbs radiation of about 150 to 450 nm. The UV absorber may additionally absorb visible radiation, for example from 350 to 750 nm.

The UV absorber(s) may be present in the imageable layer in an amount from about 10 to 50 weight %, and preferably in an amount from about 10 to 40 weight % based on the dry content of the imageable layer.

Suitable examples of UV absorbers include black dyes and/or pigments such as carbon black, metal particles and metal oxides. It may be desirable to use a carbon black having small particles for maximum color strength. Fine-grained carbon black brands with a mean particle size below 30 nm are especially suitable. The carbon black may comprise, for example, about 10-50 wt %, more particularly about 10-40 wt %, and even more particularly about 10-30 wt % of the total weight of the imageable layer.

Specific preferred UV absorbers include benzotriazoles, halogenated benzotriazoles, high molecular weight benzotriazoles, triazines, curcumines, benzophenones, benzoates, titanium or zinc oxides, campher, avobenzone, imidazoles, p-aminobenzoic acid, salicylates, substituted acrylonitriles, cyanoacrylates, benzilidene malonates, oxalanilides, UV aborbers commercially available from ADEKA such as for example ADK STAB LA-24, LA-29, LA-31R(G), LA-32, LA 36 (RG), LA-46, 1413 and mixtures thereof.

The imageable layer preferably includes at least one polymeric binder or resin. Binders or resins having hydroxyl groups such as for example poly(vinyl alcohol)s and cellulosic polymers, non-crosslinkable polyesters, polyamides, polycarbamates, polyolefins, polystyrenes, polyethers, polyvinyl ethers, polyvinyl esters, and polyacrylates and poly(meth)acrylates, terpene resins, phenolic resins, aromatic hydrocarbon resins, polyurethanes, long-chain acrylate and methacrylate resins, adhesive binders such as poly(vinyl butyral)s and phenolic resins are useful. Preferably, these polymeric binders are soluble in suitable coating solvents such as lower alcohols, ketones, ethers, hydrocarbons, and halogeno alkanes, and also preferably soluble or swellable in the developer solution.

Adhesive binders such as thermally adhesive binders having a glass transition temperature (Tg) of less than about 65 °C such as acetyl polymers and acrylamide polymers or pressure-sensitive adhesive binders are of particular interest.

The polymeric binder(s) are preferably present in an amount of from 25 to 75 weight % and more preferably in an amount from 35 to 65 weight %, based on the total dry weight of the imageable layer.

Optional other ingredients of the imageable layer include but are not limited to plasticizers, coating aids, surfactants, adhesion promotors, colorants, dispersing agents such as for example polyester/polyamine copolymers, alkyl aryl polyether alcohols and acrylic binders, contrast agents, wetting agents and fillers. These components are preferably dispersed in one or more polymeric binders that are capable of dissolving or dispersing the components in the imageable layer.

### Optional other layers

The imageable layer may optionally include other layers such as a protective layer on top of the imageable layer i.e. a thin layer transparent to UV-light which limits oxygen diffusion, e.g. polyvinylalcohol or polyamide, a non-transparent barrier layer disposed between the carrier sheet and the imageable layer, a cover sheet including methacrylic acid copolymers (such as a copolymer of ethyl methacrylate and methacrylic acid) and particles such as particles of fluoropolymers dispersed therein providing abrasion resistance to handling due to for example the presence of particles. The overcoat layer may also act as a dye barrier layer to prevent dye migration from the masking film to the photopolymer after lamination. These optional layers preferably do not significantly absorb or scatter the curing radiation, for example, they preferably do not include matte agents or other light scattering materials. The overcoat layer may be relatively thin and preferably has a dry thickness of about 0.05 to 1 µm.

### Image wise exposure

The film as described above can be image-wise irradiated. Preferred devices used for image-wise exposure are Nd/YAG lasers (1064 nm) or diode lasers (e.g. 830 nm). Following exposure to radiation and removal of the exposed portions of the imageable layer, the remaining imageable layer is referred to as the mask image.

The generation of heat in the imageable layer may then result in a physical or chemical change of the components of the imageable layer, or most preferably induce ablation. In the ablative mode of imaging the energy provided by the laser expels the imageable layer at the spot where the laser beam hits the film. A debris collector, such as, for example, a vacuum or a suitable receptor sheet, may be placed near the imageable layer to retrieve the exposed imageable layer after it is propelled from the carrier sheet.

Preferably, the exposed areas of the imageable layer are removed through ablation. The imageable layer including the combustible binders as described above, may be propelled from the carrier sheet by generation of a gas. The build-up of gas under or within the exposed areas of the imageable layer creates pressure that propels the imageable layer of the carrier sheet in the exposed areas. This action is distinguishable from other mass transfer techniques in that a chemical change (e. g. bond-breaking) rather than a physical change (e.g. melting, evaporation or sublimation) causes an almost complete transfer of the imageable layer.

### Lamination

According to the method of the present invention, after image-wise exposure, the exposed film (mask element) is laminated onto the UV-sensitive layer or protective layer of a suitable relief-forming precursor as discussed above, to make a UV-sensitive material provided with an integrated masking layer. The exposed film is preferably brought into complete optical contact with a suitable relief-forming precursor using a lamination equipment. The UV-sensitive layer of the relief-forming precursor may be tacky or may be pressure sensitive adhesive due to the presence of specific monomers.

The mask element and relief-forming precursor are preferably placed in complete optical contact so as to provide an air-free interface at the shared interface. This is typically achieved in the art by laminating the mask element to the UV-sensitive layer of the relief-forming precursor by applying suitable pressure or heat, or both pressure and heat to form an air-free or gap-free interface prior to UV exposure. Optionally, an anti-tack layer (or separation, or spacer layer) may be used.

An optional cover sheet is preferably removed before lamination. The relief-image forming assembly of the mask element and the relief-forming precursor can be fed into a laminator at a desired speed, temperature, and pressure. In the art, often a vacuum table is used to apply a balanced, non-distorting optimized lamination force to the relief forming precursor and the masking film to achieve optical contact while minimizing lateral distortion.

Useful lamination (laminator) devices and methods for using them are known in the art.

### UV exposure

Subsequently, the relief-forming precursor is subjected to flood exposure with UV-light using suitable irradiation sources of UV radiation through the mask. This causes the areas of the UV-sensitive layer which are not covered by the mask (i.e. the imageable layer) to become insoluble in a developer (negative working UV-sensitive materials) e.g. by photopolymerization or photocrosslinking) or to solubilise in a developer (positive working UV-sensitive materials). The mask image information is thus transferred to the relief-forming precursor.

Exposure can be carried out in the presence of atmospheric oxygen as the relief forming precursor and the mask are preferably in complete optical contact.

In the manufacture of the relief-forming precursor, one side of the relief-forming precursor is preferably exposed to curing UV radiation through its transparent substrate (known as "back exposure") to prepare a thin, uniform cured layer material (i.e. a floor) on the substrate side of the UV-sensitive layer. This floor provides an improved adhesion between the photopolymerizable layer and the support, helps to improve resolution and establishes the depth of the plate relief. The backside exposure can be performed before, during or after the imaging step. Preferably the backside exposure is carried out just before the UV exposure step discussed above.

The mask image is substantially opaque to the exposing or curing UV radiation, meaning that the mask image should preferably have a UV transmission optical density of 2 or more, and typically 3. The unmasked regions should be substantially transparent meaning that they should preferably have a UV transmission optical density of 0.5 or less, or even 0.2 or less. Transmission optical density can be measured using a suitable filter on a densitometer.

In the preferred negative-working embodiment, the unexposed and thus uncured regions of the UV-sensitive layer can then be removed by a developing process (described below), leaving the cured or hardened regions that define the relief image including a predetermined pattern of shapes and sizes including peaks and valleys.

The wavelength or range of wavelengths suitable as the curing UV radiation is related to the electromagnetic sensitivity of the relief-forming precursor. Preferably, the UV curing radiation can have one or more wavelengths in the range of at least 150 nm and up to and including 450 nm, or more typically of at least 300 nm and up to and including 450 nm.

Suitable sources of UV radiation for floodwise or overall exposure include but are not limited to, carbon arcs, mercury-vapor arcs, fluorescent lamps, electron flash units, and photographic flood lamps. UV radiation is particularly useful from mercury-vapor lamps and sun lamps.

The time for exposure through the mask element will depend upon the nature and thickness of the UV sensitive layer of the relief-forming precursor and the source and strength of the UV radiation. For example, about a few seconds to several minutes may be required to prepare a thin, uniform cured layer on the support side of the relief forming precursor. The relief image forming assembly of mask element and relief-forming precursor can then be exposed to UV radiation through the mask element for for example about 10 to 20 minutes.

### Delamination

After the exposure step and before development (see below), the assembly of the imaged relief-forming precursor and the mask are preferably delaminated. This can be done in various ways, e.g. manually peeling the two elements apart by for example pulling the carrier sheet including the mask away from the imaged relief-forming precursor, and/or in an automated way. Preferably, the entire imaged film - i.e. the carrier sheet and the layer(s) provided thereon - is removed and reusable.

### Development

The imaged relief-forming precursor is then preferably developed with a suitable developer (or processing solution, or washout solution) to form the relief image. During development, in the preferred negative-working embodiment, the non-exposed (uncured) regions of the UV-sensitive layer are preferably removed, leaving the exposed (cured) regions that define the relief image.

As a developer, aqueous liquids, organic solvents and/or solvent mixtures may be used; most preferably, an aqueous developer is used. Any known solvent-based or aqueous-based developer can be used, including non-chlorinated and/or chlorinated developers. For example, developers containing organic solvents such mixtures of aliphatic hydrocarbons and long chain alcohols, e.g. alcohols with at least 7 carbon atoms, perchloroethylene solvents, diethylene glycol dialkyl ethers, acetic acid esters or alcohols, carboxylic acid esters, and esters of alkoxy substituted carboxylic acids. diisopropylbenzene (DIPB), methyl esters, dipropylene glycol dimethyl ether (DME), aliphatic dibasic acid ethers, alkali metal salt of (un)saturated fatty acid having a carbon number of 12 to 18 and including mono- or poly-unsaturated fatty acids or alkali metal salts thereof; amino polycarboxylic acid or alkali metal salt thereof, and/or combinations thereof.

Development can be carried out under known conditions such as for at least 1 minute and up to and including 20 minutes and at a temperature of up to and including 50°C. The type of developing apparatus and specific developer that are used will dictate the specific development conditions and can be adapted by a skilled worker in the art.

### Post development treatments

Following the development, the obtained relief image may be dried to remove any excess solvent, for example, the relief image can be blotted or wiped dry, or dried in a forced air or infrared oven, for example during 1-4 hours at 45 °C- 65 °C for solvent developed plates and for example 10 min for water developed plates. Optimal drying times and temperatures can be defined by the person skilled in the art.

The imaged relief-forming precursor may be post-cured by exposing the relief image to curing radiation to cause further hardening or crosslinking. Post-curing can be carried out using the same type of UV-radiation previously used to expose the relief-forming precursor through the imaged mask material or for example exposure to radiation having a wavelength not higher than 300nm.

Detackification also known as light finishing can be used if the relief image surface is tacky. Such treatments, for example, by treatment with bromide or chlorine solutions or exposure to UV or visible radiation, are well known to by the person skilled in the art.

The resulting relief image may have a maximum dry depth of at least 150 µm and up to and including 1000 µm, or typically at least 200 µm and up to and including 500 µm.

The relief images obtained according to the present invention can be suitably "inked" with any desirable composition that can then be printed onto a suitable substrate or receiver material. The obtained relief image, for example a flexographic printing plate, can suitably be used for flexographic printing of for example various packaging materials.

### EXAMPLES

### 1. Components

| | |
|---|---|
| Carrier sheet: IR dye A: | polyethylene terephthalate), 175µm thick, untreated; IR absorbing dye commercially available from FEW Chemicals and having the following structure |
| | 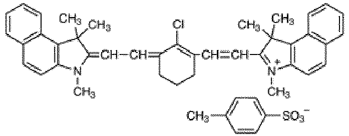 |
| Curcumin: | yellow dye commercially available from Matrix Fine Chemicals; |
| Ethyl violet: | dye commercially available from Glentham (GLS); |
| Neorez R650; | polyurethane resin commercially from Covestro; |
| DISP A: | pigment dispersion of 50/50 ratio Hostaperm Blue P-BFSTM commercially available from Clariant and Disperbyk 182 commercially available from BYK Chemie GmbH; |
| Dynoadd F-100: | wetting agent commercially available from Dynea; |
| Mowiol 4-88: | partially hydrolyzed polyvinyl alcohol commercially available from Kuraray; |
| MEK: | methyl ethyl ketone available from for example Sigma-Aldrich; |
| Dowanol PM: | 1-methoxy-2-propanol available from for example Sigma-Aldrich. |
| Tego glide 410: | polydimethylsiloxane-polyether surfactant commercially available from Evonik |

### Example 1

### 1. Preparation of the imageable films

On carrier sheet A, the imageable layers were coated including the components shown in the following Tables 1 and 2 using a wire coating rod. The resulting coating was dried at room temperature to form an imageable layer with a coating coverage of 1.6 g/m².

**Table 1: Inventive films Inv-01 to Inv-04**

| Imageable layer formulation | Inv-01 % wt | Inv-02 % wt | Inv-03 % wt | | Inv-04 %wt | |
|---|---|---|---|---|---|---|
| IR dye A | 18.6 | 18.6 | | 22.2 | | 25.5 |
| Curcumin | 49.9 | 49.9 | | 47.7 | | 45.7 |
| Nitrocellulose | 12.9 | 12.9 | | 12.3 | | 11.8 |
| NeoRez R650 | 6.5 | 6.5 | | 6.2 | | 5.9 |
| Dynoadd | 1 | 0.9 | | 0.9 | | 0.9 |
| DISP A | 8.8 | 8.7 | | 8.4 | | 8.0 |
| Ethyl violet | 2.2 | 2.2 | | 2.1 | | 2.0 |
| Tego glide 410 | 0.2 | 0.4 | | 0.2 | | 0.2 |

**Table 2: Comparative films Comp-01 and Comp-02**

| | Coated imageable film | |
|---|---|---|
| | | |
| Imageable layer formulation | Comp-01 % wt | Comp-02 %wt |
| IR dye A | 18.6 | 18.6 |
| Curcumin | 49.9 | 49.9 |
| Nitrocellulose | 12.9 | 12.9 |
| NeoRez R650 | 6.6 | 6.5 |
| Dynoadd | 1 | 1 |
| DISP A | 8.9 | 8.8 |
| Ethyl violet | 2.2 | 2.2 |
| Tego glide 410 | - | - |
| Lubaprint 887/H | - | 0.2 |

### 2. Results

The cosmetic and physical properties, UV density and ablative sensitivity of the obtained films were evaluated. The results are summarized in Table 3.

The results show that the addition of the polysiloxane compound highly improves the scratch resistance of the imageable coating without deteriorating its ablative sensitivity (Inv-01 to Inv-04 compared to Comp-01). The addition of carnauba wax decreases the scratch resistance of the imageable coating but also highly reduces its ablative sensitivity (Comp-02).

**Table 3: Cosmetic properties, UV density and ablative sensitivity results**

| Film | Coating quality | | Scratch resistance | | UV density | | Ablative Sensitivity | |
|---|---|---|---|---|---|---|---|---|
| Inv-01 | | + + | | + | | + + | | + + |
| Inv-02 | | + | | + + | | + + | | + + |
| Inv-03 | | + + | | + + | | + + | | + |
| Inv-04 | | + + | | + + | | + + | | + + |
| Comp-01 | | + + | | - | | + + | | + + |
| Comp-02 | | + | | - | | + | | - |

### Example 2

### 1. Preparation of the imageable films

The imageable layers were coated on the carrier sheet including the components shown in the following Table 4 using a wire coating rod. The resulting coating was dried at room temperature to form an imageable layer with a coating coverage of 1.6 g/m².

**Table 4: Inventive films Inv-01 to Inv-04 and comparative film Comp-03**

| Imageable layer formulation | Inv-01 % wt | Inv-02 % wt | Inv-03 % wt | | Inv-04 % wt | | Comp-03 %wt | |
|---|---|---|---|---|---|---|---|---|
| IR dye A | 18.6 | 18.6 | | 22.2 | | 25.5 | | 28.5 |
| Curcumin | 49.9 | 49.9 | | 45.7 | | 45.7 | | 43.8 |
| Nitrocellulose | 12.9 | 12.9 | | 12.3 | | 11.8 | | 11.2 |
| 12.3NeoRez R650 | 6.5 | 6.5 | | 6.2 | | 5.9 | | 5.7 |
| Dynoadd | 1 | 0.9 | | 0.9 | | 0.9 | | 0.9 |
| DISP A | 8.8 | 8.7 | | 8.4 | | 8.0 | | 7.7 |
| Ethyl violet | 2.2 | 2.2 | | 2.1 | | 2.0 | | 2.0 |
| Tego glide 410 | 0.2 | 0.4 | | 0.2 | | 0.2 | | 0.2 |

### 2. Results

Each of the resulting films was evaluated for UV density and ablative sensitivity. The results are summarized in Table 5.

The results show that when the level of the infrared absorbing dye is increased from 292 mg/m² to 365 mg/m² the ablative sensitivity remains excellent (Inv-01 to Inv-03). Increasing the level further to 438 mg/m² (Inv-04), the ablative sensitivity remains good; however, increasing further to a level of 511 mg/m2 (Comp-03) shows an unacceptable ablation sensitivity of the imageable film.

**Table 5: UV density and ablative sensitivity results**

| Film | UV density | | Ablative Sensitivity | |
|---|---|---|---|---|
| Inv-01 | | + + | | + + + |
| Inv-02 | | + + | | + + + |
| Inv-03 | | + + | | + + + |
| Inv-04 | | + + | | + |
| Comp-03 | | + + | | - |

### Example 3

### 1. Preparation of the imageable films

The imageable layers were coated on the carrier including the components shown in the following Table 6 using a wire coating rod. The resulting coating was dried at room temperature to form an imageable layer.

**Table 6: composition of the coating of the inventive and comparative films**

| Imageable layer formulation | Inv-05 | Inv-06 | Inv-07 | Inv-08 | Inv-09 | Inv-10 | Inv-11 |
|---|---|---|---|---|---|---|---|
| | % wt | | | | | | |
| IR dye A | 22.22 | 22.21 | 22.20 | 22.17 | 22.13 | 22.09 | 22.01 |
| Curcumin | 47.78 | 47.76 | 47.73 | 47.69 | 47.60 | 47.52 | 47.35 |
| Nitrocellulose | 12.36 | 12.35 | 12.34 | 12.33 | 12.31 | 12.31 | 12.24 |
| NeoRez R650 | 6.21 | 6.21 | 6.20 | 6.20 | 6.19 | 6.17 | 6.15 |
| Dynoadd | 0.91 | 0.91 | 0.91 | 0.91 | 0.91 | 0.91 | 0.90 |
| DISP A | 8.40 | 8.40 | 8.39 | 8.38 | 8.37 | 8.35 | 8.32 |
| Ethyl violet | 2.13 | 2.13 | 2.13 | 2.13 | 2.12 | 2.12 | 2.11 |
| Tego glide 410 | / | 0.05 | 0.09 | 0.18 | 0.36 | 0.54 | 0.90 |

The pull-off force needed to separate (delaminate) the ablatable film from the photopolymer layer was measured using a PESOLA Medio Line spring scale.

First, the ablatable film was laminated onto the photopolymer layer. After one hour, the hook of the spring scale was fixed to one edge of the ablatable film and the film was then pulled-off from the photopolymer layer at a constant speed. Two pull-off forces were measured: the initial force required to start the delamination and then the pull-off force needed to completely remove the ablatable film from the photopolymer layer.

The results of the peal force test summarised in Table 7 below show that both the initial pull-off force and the constant pull-off force are highly reduced for the Inventive Examples including the silicone surfactant.

**Table 7: Results of the pull-off forces**

| Pull-off force expressed in gram | Inv-05 | Inv-06 | Inv-07 | Inv-08 | Inv-09 | Inv-10 | Inv-11 |
|---|---|---|---|---|---|---|---|
| Initial pull-off force | 100-75 | 75 | 50 | 50 | 50 | 30-40 | 30-40 |
| "constant" Pull-off force | 250-300 | 150 | 150 | 150 | 150 | 100-150 | 100-150 |

## Claims

1. A film comprising
- a transparent carrier sheet, and
- an imageable layer including an infrared absorbing compound, an UV absorber and a heat combustable binder,
**characterised in that** the imageable layer further includes a polysiloxane compound.

2. The film according to claim 1 wherein the polysiloxane compound includes at least one siloxane group -Si(R,R')-O-, wherein R and R' independently represent an optionally substituted alkyl or aryl group.

3. The film according to claim 2 wherein the number of siloxane groups
-Si(R,R')-O- is at least 2.

4. The film according to any of the preceding claims wherein the polysiloxane compound further includes alkylene-oxide units according to the formula
-CnH2n-O- wherein n is preferably an integer in the range 2 to 5.

5. The film according to any of the preceding claims wherein the polysiloxane compound is present in the imageable layer in an amount of 0.01 to 1.5%wt.

6. The film according to any of the preceding claims wherein the transparent carrier sheet is un subbed polyethylene terephthalate, polyethylene naphthalate, fluorene polyester polymers, polyethylene, polypropylene, polybutadienes, polyacrylates, polycarbonates, polyvinyl chloride and copolymers thereof.

7. The film according to any of the preceding claims wherein the IR light absorbing compound is a IR light absorbing dye selected from phthalocyanine dyes, cyanine dyes, merocyanine dyes, and polymethine dyes and/or derivatives thereof.

8. The film according to any of the preceding claims wherein the concentration of the infrared absorbing compound is ≤ 28%wt relative to the total amount of the dry composition.

9. The film according to any of the preceding claims wherein the concentration of the infrared absorbing compound is ≤ 25%wt relative to the total amount of the dry composition.

10. The film according to any of the preceding claims wherein the film includes a toplayer including PVOH.

11. The film according to any of the preceding claims wherein the film consists of a carrier sheet and an imageable layer.

12. A method for making a relief image comprising the steps of:
a) image wise exposing the imageable film according to claims 1 to 11 whereby an imaged film including a mask image is formed;
b) laminating the imaged film including the mask image to an imageable article comprising a substrate and a photosensitive material;
c) exposing the imageable article comprising the imaged film including the mask image to curing radiation whereby an imaged article is formed;
d) removing the imaged film including the mask image from the imaged article; and
e) developing the imaged article to form the relief image.

13. The method according to claim 12 wherein the exposed areas of the imageable layer are removed through ablation.

14. The method according to claims 12 or 13 wherein the imageable article is a flexographic printing plate precursor, a letterpress printing plate precursor or a printed circuit board.

15. The method according to claims 12 to 14 wherein the imageable article is a flexographic printing plate precursor.
